# EUROPEAN PATENT SPECIFICATION

(11) **EP 3 893 621 B1**
(45) Date of publication and mention of the grant of the patent: **22.11.2023**
(21) Application number: 18942548.1
(22) Date of filing: 07.12.2018
(51) Int. Cl.: H05K 13/08, H05K 13/02

(54) **MACHINE MANAGEMENT SYSTEM FOR SUBSTRATE-WORKING MACHINES**
MASCHINENVERWALTUNGSSYSTEM FÜR SUBSTRATBEARBEITUNGSMASCHINEN
SYSTÈME DE GESTION DE MACHINE POUR MACHINES DE TRAVAIL DE SUBSTRAT

(43) Date of publication of application: 13.10.2021
(73) Proprietor: Fuji Corporation, Chiryu-shi, Aichi 472-8686 (JP)
(72) Inventor: MATSUYAMA, Kazuya, Chiryu-shi, Aichi 472-8686 (JP)
(74) Representative: Grünecker Patent- und Rechtsanwälte PartG mbB
(86) International application number: PCT/JP2018/045192
(87) International publication number: WO 2020/115915

(56) References cited:
- JP-A- H 066 084
- JP-A- 2016 018 968
- JP-A- 2017 216 379
- JP-A- 2017 224 720
- JP-A- 2017 224 720
- US-A1- 2017 354 070

## Description

### Technical Field

The present invention relates to a device management system for substrate-working machines.

### Background Art

The device management system is used for the management of component devices in a storage or a substrate-working machine. The substrate-working machine used for manufacturing a substrate product includes a component mounter that mounts a component on a substrate. The component mounter includes component devices such as a feeder that supplies a component. In the setup before production, the feeder is exchanged in accordance with the type of the substrate product, and is conveyed between the storage and the component mounter by a conveyance carriage. Patent Literature 1 discloses a configuration for optimizing the contents and timing of setup corresponding to a production schedule of a substrate product.
Patent Literature 2 relates to an electronic component supply system. The electronic components are supplied to an electronic component mounting machine using a splicing unit. The position of a reel loaded in a feeder is specified, where a bar code is detected by a bar code reader, as a specified current position of a splicing unit. Based on this specified current position, a supply object tape feeder for supplying an electronic component next by a splicing device is determined.
Patent Literature 3 relates to a component mounting system. The system includes a mobile component supply device that holds a tape cassette storing a component, automatically moves, and supplies the component in the tape cassette to the tape feeder.

### Patent Literature

Patent Literature 1: JP-A-2000-059090
Patent Literature 2: JP 2017 224720 A
Patent Literature 3: US 2017/354070 A1

### Summary of the Invention

### Technical Problem

However, when the frequency of the movement by the conveyance carriage or the exchange of the component device is increased, it becomes difficult to always grasp the location of the conveyance carriage or the component device. Further, it is conceivable to improve the manageability by regulating a stop position of the conveyance carriage or the accommodation state of the component device in the conveyance carriage before and after the setup. On the other hand, if such a regulation is provided, there is a concern that the movement distance of the conveyance carriage may be extended, or the operation for unloading the component device from the conveyance carriage may be increased.

An object of the present specification is to provide a device management system for substrate-working machines, which is possible to improve the manageability of a component device and also improve the work efficiency of setup using a conveyance carriage.

### Solution to Problem

The present invention is defined by the features of the independent claims. The present specification discloses a device management system for substrate-working machines that includes a conveyance carriage configured to accommodate a component device exchangeably mounted on a substrate-working machine and used for a predetermined work on a substrate, and to be movable within a movement range including a storage that stores the component device and including the substrate-working machine, a position detection section configured to detect a current position of the conveyance carriage in the movement range, an information acquisition section configured to be provided on the conveyance carriage and acquiring identification information of the component device accommodated in the conveyance carriage, and a management control section configured to manage the conveyance carriage and the component device based on a detection result by the position detection section and the identification information by the information acquisition section.

### Advantageous Effect of the Invention

With such a configuration, the current position of the conveyance carriage is detected by the position detection section, and the component device accommodated in the conveyance carriage can be managed based on the identification information. Accordingly, it is possible to improve the manageability of the conveyance carriage and the component device. The operator is assisted in the setup by managing such as a component device by the device management system. As a result, it is possible to improve the work efficiency of the setup using the conveyance carriage.

### Brief Description of Drawings

FIG. 1 is a schematic diagram illustrating a production system to which a device management system according to an embodiment is applied.
FIG. 2 is a schematic diagram illustrating a configuration of a component mounter that configures the production line in FIG. 1.
FIG. 3 is a plan view schematically illustrating a conveyance device that configures the device management system in FIG. 1.
FIG. 4 is a plan view illustrating a terminal device that configures the device management system in FIG. 1, and illustrating a state in which a search result of a predetermined component device is presented on a screen.
FIG. 5 is a flowchart illustrating a management control process of a component device.

### Description of Embodiments

### 1. Summary of Device Management System 20

An embodied embodiment of device management system 20 will be described below with reference to the drawings. Device management system 20 is exchangeably mounted on a substrate-working machine and is used for the management of component devices used for a predetermined work on a substrate. In the present embodiment, a mode in which feeder 122 of component mounter 3 as a substrate-working machine is managed as the management subject by device management system 20 will be exemplified.

### 2. Configuration of Production System 1

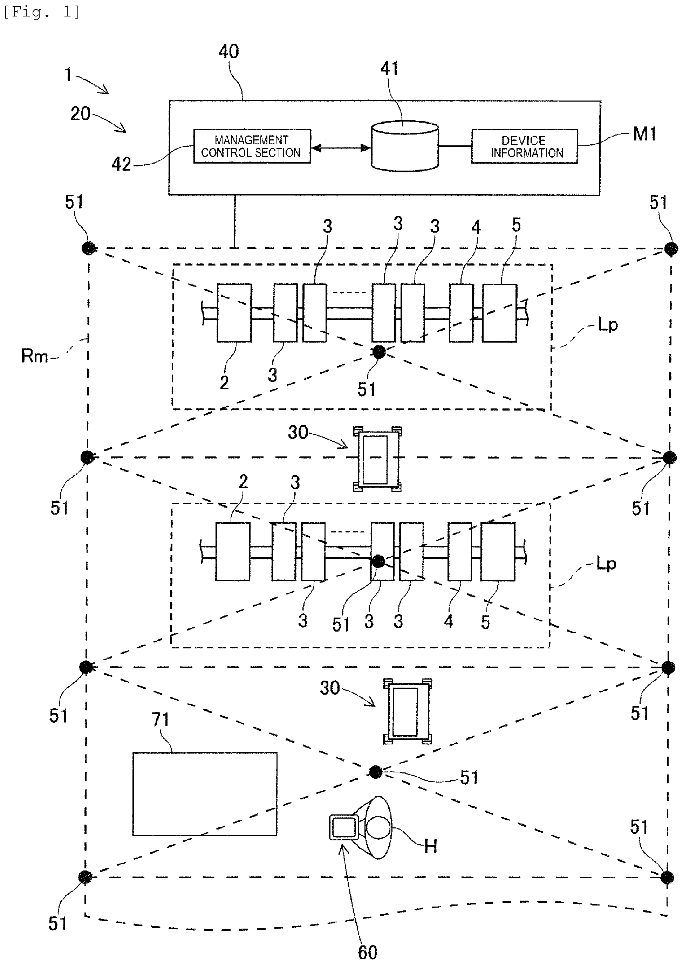

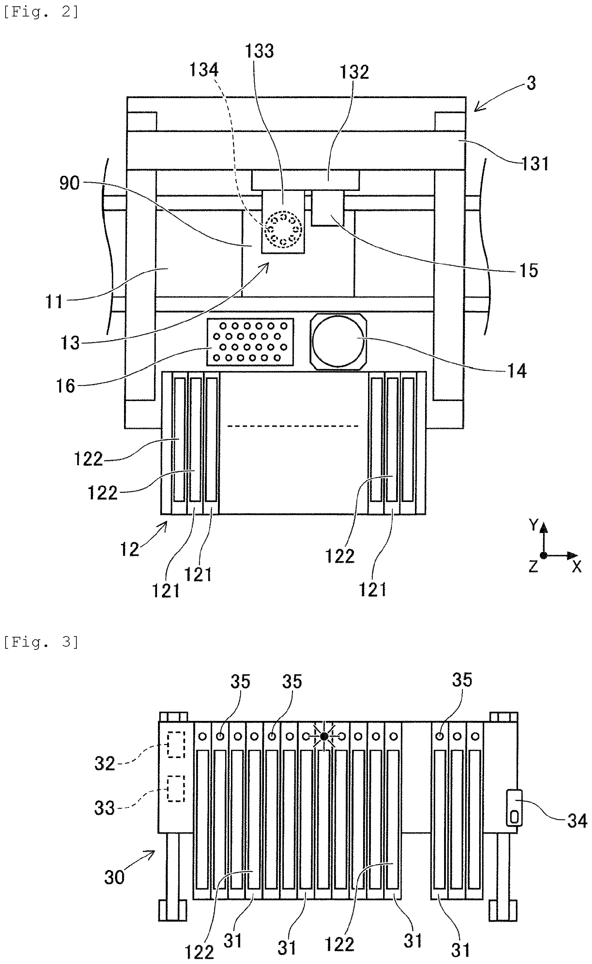

As illustrated in FIG. 1, production system 1 includes multiple production lines Lp, device management system 20, and storage 71. Production line Lp is configured, for example, in a production plant of a substrate product, by installing multiple substrate-working machines in the conveyance direction of substrate 90 (refer to FIG. 2). Each of the multiple substrate-working machines is communicably connected to management server 40 functioning as a host computer that collectively controls production line Lp. Production line Lp includes printer 2, multiple component mounters 3, reflow furnace 4, and inspector 5 as multiple substrate-working machines.

Printer 2 prints paste-like solder at a mounting position of the components on substrate 90 that has been conveyed in. Specifically, printer 2 spreads solder to the mask in a state where a mask is overlapped on substrate 90 (not illustrated). As a result, the solder is printed at a position corresponding to the pattern hole formed in the mask. Each of multiple component mounters 3 mounts a component on substrate 90 conveyed from an upstream side of production line Lp. A configuration of component mounter 3 will be described later.

Reflow furnace 4 heats substrate 90 conveyed from the upstream side of production line Lp, melts the solder on substrate 90, and performs soldering. Inspector 5 inspects whether the function of the substrate product produced by production line Lp is normal. The configuration of production line Lp can be appropriately added or changed corresponding to, for example, the type of substrate product to be produced. Specifically, substrate-working machines such as a buffer device for temporarily holding conveyed substrate 90, a substrate supply device, a substrate flipping device, various inspection devices, a shield mounting device, an adhesive application device, an ultraviolet ray irradiation device can be installed appropriately in production line Lp.

Storage 71 is installed in the floor of the production plant and stores the component devices. Storage 71 stores, for example, feeder 122 which is one type of component devices, as a storage subject. At this time, storage 71 stores feeder 122 in a state in which the carrier tape is loaded in feeder 122 or in a state in which the carrier tape is not loaded. In addition, storage 71 recognizes the component devices that are stored and the state of the component devices by acquiring the identification information of the component devices conveyed in and conveyed out.

### 3. Configuration of Component Mounter 3

Component mounter 3 executes a mounting process for mounting a component on substrate 90. As illustrated in FIG. 2, component mounter 3 includes substrate conveyance device 11, component supply device 12, component transfer device 13, part camera 14, substrate camera 15, and nozzle station 16. Substrate conveyance device 11 is configured by a belt conveyor, a positioning device, and the like. Substrate conveyance device 11 sequentially conveys substrate 90 in the conveyance direction, and positions substrate 90 at a predetermined position in the device. Substrate conveyance device 11 conveys out substrate 90 to the outside of component mounter 3 after the completion of a mounting process.

Component supply device 12 supplies components to be mounted on substrate 90. Component supply device 12 includes feeders 122 set in multiple slots 121. Feeder 122 feeds and moves a carrier tape in which multiple components are stored, and supplies the components such that the components can be picked up. Feeder 122 is one of the component devices that configure component mounter 3. Feeder 122 stores unique identification information (ID) to an internal storage device. Feeder 122 transmits the identification information in response to a request from the outside in a state where feeder 122 is communicably connected to the outside.

Component transfer device 13 transfers a component supplied from component supply device 12 to a predetermined mounting position on substrate 90 conveyed in the device by substrate conveyance device 11. Head driving device 131 of component transfer device 13 moves moving body 132 in a horizontal direction (a X-axis direction, a Y-axis direction) with a linear motion mechanism. Mounting head 133 is exchangeably fixed to the moving body 132 by a clamp member (not illustrated).

Mounting head 133 is one of the component devices that configure component mounter 3. In a mounting process, mounting head 133 picks up a component using suction nozzle 134, adjusts the position in vertical direction and angle of the component, and mounts the component on substrate 90. Suction nozzle 134 is a holding member that picks up and holds components by the supplied negative pressure air. In addition to suction nozzle 134, a chuck or the like holding a component can be attached to mounting head 133 as a holding member.

Part camera 14 and substrate camera 15 are digital imaging devices having imaging elements such as a CMOS. Part camera 14 and substrate camera 15 perform imaging based on control signals and transmit image data acquired by the imaging. Part camera 14 is configured to be capable of imaging components held by suction nozzle 134 of mounting head 133 from below. Substrate camera 15 is configured to be capable of imaging substrate 90 from above.

Nozzle station 16 is installed on the base of component mounter 3. Nozzle station 16 detachably holds multiple suction nozzles 134. In a exchange process of suction nozzle 134, nozzle station 16 holds suction nozzle 134 detached from mounting head 133 and also detachably holds other suction nozzles 134. As a result, component mounter 3 is configured to automatically exchangeable suction nozzle 134 in accordance with the type of the electronic component of the mounting target during the execution of a mounting process.

Component mounter 3 having the configuration as described above executes a mounting process that mounts components on substrate 90. In a mounting process, component mounter 3 transmits a control signal to component transfer device 13 based on the control program stored in advance in accordance with the information output from various sensors and the result of image processing. As a result, the positions and angles of multiple suction nozzles 134 supported by mounting head 133 are controlled.

### 4. Configuration of Device Management System 20

Device management system 20 manages component devices such as feeder 122. As a result, the location and the state of the component devices are grasped, and the setup efficiency of the substrate-working machine for the production of the substrate product is improved. In addition, appropriate operation of component device is maintained by performing maintenance in accordance with the state of the component device. In the present embodiment, device management system 20 includes, as illustrated in FIG. 1, multiple conveyance carriages 30, management server 40, multiple beacon devices 51, and terminal device 60.

Conveyance carriage 30 accommodates multiple feeders 122 and is configured to be movable in movement range Rm including storage 71 and component mounter 3. In the present embodiment, conveyance carriage 30 travels by an operation force from the outside. That is, conveyance carriage 30 does not include a driving section or the like, and travels on the floor by being pushed by operator H. Conveyance carriage 30 is used for a predetermined work with respect to storage 71 or component mounter 3 (for example, an exchange work of feeder 122) in a state where conveyance carriage 30 is stopped at a random position in movement range Rm.

As illustrated in FIG. 3, conveyance carriage 30 includes multiple accommodation sections 31, position detection section 32, information acquisition section 33, reader device 34, and notification section 35. Multiple accommodation sections 31 are configured similarly to multiple slots 121 in component supply device 12, and support feeders 122. Feeder 122 accommodated in each of multiple accommodation sections 31 is supplied with electric power from conveyance carriage 30 and is placed in a communicable state.

Position detection section 32 detects current position Pc of conveyance carriage 30 in movement range Rm. Various modes can be employed for a detection process of current position Pc by position detection section 32. In the present embodiment, position detection section 32 performs the detection process based on an external signal. Specifically, position detection section 32 is provided on conveyance carriage 30 and receives signals from multiple beacon devices 51 and detects current position Pc of conveyance carriage 30.

Here, each of multiple beacon devices 51 is installed in movement range Rm and is a transmitter that transmits a predetermined signal. In the present embodiment, each of multiple beacon devices 51 transmits a signal corresponding to an installation position. Position detection section 32 receives the beacon signals transmitted by multiple beacon devices 51, and determines current position Pc in movement range Rm based on the signal strengths. Position detection sections 32 of multiple conveyance carriages 30 disposed in the same movement range Rm are the same type and share multiple beacon devices 51. As a result, it is possible to reduce the facility cost.

As described above, position detection section 32 of the present embodiment is provided on conveyance carriage 30, periodically acquires current position Pc of conveyance carriage 30, and transmits current position Pc to management server 40 in association with the identification information of conveyance carriage 30. As a result, management server 40 is configured to be recognizable whether each of multiple conveyance carriages 30 disposed within movement range Rm is within movement range Rm, and configured to be recognizable current position Pc in movement range Rm.

Information acquisition section 33 is provided on conveyance carriage 30 to acquire the identification information of the component devices accommodated in conveyance carriage 30. Specifically, information acquisition section 33 acquires the identification information by communicating with feeder 122 communicably connected to conveyance carriage 30. Information acquisition section 33 may acquire the identification information by reading an identification code (not illustrated) attached to feeder 122 accommodated in conveyance carriage 30.

The identification code includes unique information of feeder 122 such as identification information. As the identification code, a bar code, a two-dimensional code, a character string, a pattern, a color, or a combination thereof may be employed. Reader device 34 can read the identification code attached to feeder 122 and the identification code attached to the reel around which the carrier tape is wound. As a result, when a predetermined carrier tape is loaded in feeder 122, each identification code is read by reader device 34, such that feeder 122 and the carrier tape are associated with each other.

In a case where the carrier tape is associated with predetermined feeder 122 as described above, conveyance carriage 30 transmits the information to management server 40. As a result, management server 40 is configured to be recognizable whether the carrier tape is loaded in any feeder 122, and in a case where the carrier tape is loaded, and configured to be recognizable the component types and the remaining number of the components. Reader device 34 may employ a handy type that can be operated by operator H, or other types. For example, reader device 34 may be configured by a camera device having a visual field for camera corresponding to the attachment position of the identification code, and an image processing device that reads the identification information by image processing.

Multiple notification sections 35 are provided corresponding to multiple accommodation sections 31. Each of multiple notification sections 35 notifies operator H of the position of specific feeder 122 in conveyance carriage 30. Specifically, in the present embodiment, notification section 35 is a display lamp provided on an upper portion of conveyance carriage 30 that can be visually recognized by operator H. Notification section 35 can be switched the states of turned-on, blinking, and turn-off by an instruction from management control section 42 which will be described later. In addition, notification section 35 may notify the position of feeder 122, for example, when conveyance carriage 30 detects the approach of operator H or receives a notification request from operator H.

### 5. Configuration of Management Server 40

Management server 40 functions as a host computer that collectively controls multiple production lines Lp in a production plant. In addition, management server 40 monitors the operation status of production line Lp, and manages component mounter 3 and storage 71. Various data for controlling component mounter 3 are stored in management server 40. Management server 40 appropriately transmits various data such as a control program to each production facility when executing a production process in each production facility.

Here, when the frequency of the movement by conveyance carriage 30 or the exchange of feeder 122 used for setup or the like in the production plant is increased, it is difficult to always grasp the locations of conveyance carriage 30 and feeder 122. In particular, since conveyance carriage 30 does not have a self-driving function and travels by the operation force of operator H, it is difficult to grasp current position Pc. Accordingly, device management system 20 employs the following configuration in order to improve the manageability of feeder 122 and improve the work efficiency of the setup using conveyance carriage 30.

Specifically, in the management for feeder 122, management server 40 communicates with, for example, multiple component mounters 3, conveyance carriage 30, and storage 71, and collects the identification information of feeder 122 mounted on or accommodated in each them. As a result, management server 40 recognizes, for example, specific feeder 122 is set in which slot 121 of component supply device 12 in any component mounter 3. Further, as illustrated in FIG. 1, management server 40 includes storage section 41 and management control section 42.

Storage section 41 stores device information M1 for multiple feeders 122 in association with the identification information (ID). In the present embodiment, device information M1 includes the necessity of maintenance of corresponding feeder 122. Here, in order to maintain a stable operation, feeder 122 requires maintenance in accordance with the operation number (corresponding to, for example, the supply number of the component), the operation time, and the elapsed time from the previous maintenance.

Management server 40 calculates the necessity of maintenance for each feeder 122 based on the operation number or the like, and records the calculated necessity in device information M1. Device information M1 may include, for example, the type of feeder 122, the version of the installed firmware, the component type which is loaded, and the remaining number of components.

Management control section 42 manages conveyance carriage 30 and feeder 122 based on the detection result by position detection section 32 and the identification information by information acquisition section 33. In the present embodiment, management control section 42 recognizes each current position Pc of multiple conveyance carriages 30 in movement range Rm, and each location of component mounter 3, conveyance carriage 30, and storage 71 set in feeder 122. As a result, device management system 20 improves the manageability of feeder 122.

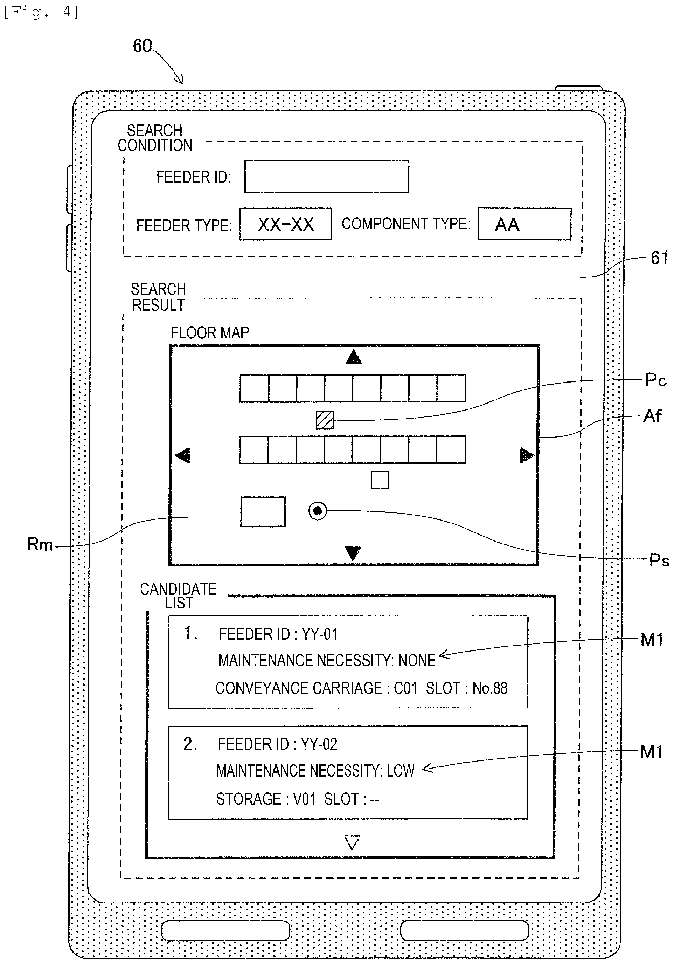

In the present embodiment, management control section 42 receives a search request for specific feeder 122 from operator H using the functions described above. Specifically, management control section 42 receives a search request from operator H from terminal device 60. Terminal device 60 is, for example, a tablet carried by operator H. In the present embodiment, terminal device 60 includes touch screen 61 as illustrated in FIG. 4. Touch screen 61 displays various information and receives an operation by operator H.

Terminal device 60 is communicably connected to management server 40. In addition, terminal device 60 is configured that can acquire self-position Ps in movement range Rm. In the present embodiment, terminal device 60 receives the beacon signals transmitted from multiple beacon devices 51 in the same manner as position detection section 32, and determines self-position Ps in movement range Rm based on the signal strengths thereof. In addition, terminal device 60 stores map Af in advance that includes positions where multiple production lines Lp and storage 71 are installed in the production plant.

As described above, when receiving a search request for specific feeder 122 from operator H, management control section 42 searches feeder 122 based on various types of information that has been recognized. Then, management control section 42 presents current position Pc of conveyance carriage 30 that accommodates feeder 122 to operator H as a search result. At this time, management control section 42 causes touch screen 61 of terminal device 60 to display current position Pc of conveyance carriage 30 and self-position Ps of terminal device 60 in an overlapping manner on map Af indicating movement range Rm.

Further, in the present embodiment, management control section 42 presents device information M1 acquired from management server 40 to operator H in addition to the search result. As a result, operator H can confirm device information M1 such as the necessity of the maintenance of feeder 122 together with the location of searched feeder 122. As a result, it is possible to prevent feeder 122 having a high maintenance necessity from being set. In addition, since current position Pc of conveyance carriage 30 in which self-position Ps and feeder 122 are accommodated is displayed on map Af, the access to feeder 122 is facilitated.

With respect to the search request, management control section 42 may receive various conditions in addition to receiving input of the identification information indicating specific feeder 122. Specifically, management control section 42 may receive, for example, the type of feeder 122, the version of the installed firmware, the component type which is loaded, the remaining number of the components, and the like as complex conditions, and search for feeder 122 satisfying the conditions.

As described above, specific feeder 122 is searched by receiving the conditions, and multiple feeders 122 satisfying the conditions may be detected. In such a case, management control section 42 may set each of multiple feeders 122 as a candidate, and present the search results (multiple candidates) to operator H in an order based on a predetermined priority. A low necessity of maintenance or a close distance from self-position Ps can be optionally set as the predetermined priority.

In addition, in the present embodiment, management control section 42 presents the search results in terminal device 60 to operator H as described above, and causes notification section 35 corresponding to accommodation section 31 that accommodates specific feeder 122 to perform notification. Specifically, management control section 42 causes conveyance carriage 30 to turn-on notification section 35 related to the search results. As a result, operator H can visually recognize which accommodation section 31 accommodates target feeder 122 when approaching conveyance carriage 30. Accordingly, it is possible to improve the work efficiency.

When specific feeder 122 as described above is searched, feeder 122 may be set in predetermined slot 121 of component supply device 12 in component mounter 3, or may be stored in storage 71. In such a case, management control section 42 causes terminal device 60 to display self-position Ps and the position of feeder 122 in an overlapping manner on map Af, similarly to the case where self-position Ps and feeder 122 are accommodated in conveyance carriage 30.

Further, when specific feeder 122 as described above is searched, conveyance carriage 30 that accommodates feeder 122 corresponding to the search request need not be in movement range Rm. Specifically, in general, management server 40 periodically acquires current position Pc of conveyance carriage 30 but recognizes that conveyance carriage 30 has been moved outside movement range Rm when the last detected current position Pc is retroactive to a certain period from the current time.

In such a case, management control section 42 presents to operator H that conveyance carriage 30 is outside movement range Rm and the final position finally detected by position detection section 32, as search results. The "final position" corresponds to the last current position Pc transmitted from conveyance carriage 30. With such a configuration, operator H can immediately grasp that feeder 122 being searched for is not present on the floor, and can also grasp, for example, from which doorway the feeder 122 has moved to the outside. As a result, it is possible to assist operator H in estimating the location of feeder 122.

### 6. Management Control Process by Device Management System 20

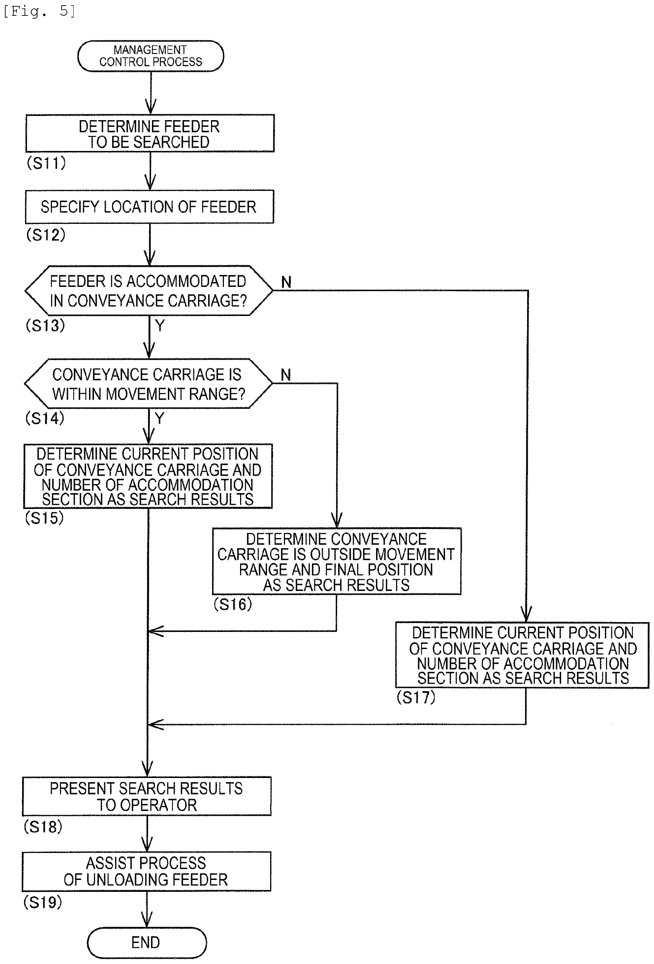

A management control process by device management system 20 will be described with reference to FIG. 5. Here, the component device subject to the management control process is feeder 122 of component supply device 12 in component mounter 3. In addition, management server 40 of device management system 20 holds the identification information of feeder 122 set in each of component mounters 3, conveyance carriages 30, and storage 71 as location information by communicating with multiple component mounters 3, multiple conveyance carriages 30, and storage 71. In addition, management server 40 holds each current position Pc as location information by communicating with multiple conveyance carriages 30.

Management server 40 executes the management control process, for example, when a search request for specific feeder 122 is received from operator H via terminal device 60. Here, operator loads a predetermined carrier tape in specific feeder 122 according to the setup list generated in accordance with the production schedule of the substrate product, and mounts specific feeder 122 in component mounter 3. At this time, operator H performs setup work such as conveying multiple feeders 122 to target component mounter 3 using conveyance carriages 30, and adjusting the state of feeders 122.

At this time, in a case where operator H is not possible to grasp the location of specific feeder 122 or conveyance carriage 30, the progress of the setup operation will be delayed. Accordingly, operator H operates terminal device 60 to make an inquiry (search request) to management server 40 in order to acquire the locations and the states of specific feeder 122 and conveyance carriage 30. Management control section 42 determines feeder 122 to be searched based on the identification information or the search conditions input to terminal device 60 (step S11). At this time, when multiple feeders 122 corresponds to the search conditions, management control section 42 makes each feeder 12 a candidate.

Next, management control section 42 specifies the location of specific feeder 122 determined in step S11 based on the location information held in advance (step S12). At this time, when specific feeder 122 is set in component mounter 3 or conveyance carriage 30, the predetermined information includes the information indicating which slot 121 or accommodation section 31 sets feeder 122. Subsequently, management control section 42 determines whether specific feeder 122 is accommodated in the conveyance carriage 30 (step S13).

When specific feeder 122 is accommodated in conveyance carriage 30 (step S13: Yes) and conveyance carriage 30 is within movement range Rm (step S14: Yes), management control section 42 determines that current position Pc of conveyance carriage 30 and the number of accommodation section 31 as search results (step S15). On the other hand, when conveyance carriage 30 is outside movement range Rm (step S14: No), management control section 42 determines that conveyance carriage 30 is outside movement range Rm and the final position (current position Pc at the time of the last detection) as search results (step S16).

When specific feeder 122 is not accommodated in conveyance carriage 30 (step S13: No), management control section 42 determines that the installation position of component mounter 3 and the number of slot 121, or the installation position of storage 71 as the search results (step S17). Management control section 42 transmits the search results generated by any one of step S15 to step S17 to terminal device 60, and presents the search results to operator H (step S18). At this time, management control section 42 transmits device information M1 related to specific feeder 122 to terminal device 60 together with the search results.

Terminal device 60 displays self-position Ps and the search result (such as current position Pc of conveyance carriage 30) in an overlapping manner on map Af. At this time, terminal device 60 displays device information M1 related to feeder 122 on map Af or in alignment with map Af. When there are multiple candidates, terminal device 60 displays the position and device information M1 in accordance with the order according to the display priority.

In addition, management control section 42 executes an assist process of unloading by operator H as required (step S19). Specifically, when specific feeder 122 is accommodated in conveyance carriage 30, management control section 42 causes notification section 35 corresponding to accommodation section 31 that accommodates feeder 122 with respect to conveyance carriage 30 to perform notification. As a result, when notification section 35 is a display lamp, the display lamp is turned on to improve the visibility of operator H.

In addition, in the assist process, when specific feeder 122 is stored in storage 71, management control section 42 may instruct storage 71 to put out feeder 122 such that operator H can unload feeder 122. As a result, operator H, for example, pushes conveyance carriage 30 to move to storage 71, such that put out feeder 122 can be carried out from storage 71.

### 7. Effects of Configuration of Embodiments

Device management system 20 of the substrate-working machines in the present embodiment includes position detection section 32 that detects current position Pc of conveyance carriage 30 in movement range Rm, information acquisition section 33 that acquires the identification information of the component devices (feeders 122) accommodated in conveyance carriage 30, and management control section 42 that manages conveyance carriage 30 and the component device based on the detection result by position detection section 32 and the identification information by information acquisition section 33.

With such a configuration, current position Pc of conveyance carriage 30 is detected by the position detection section 32, and the component devices (feeders 122) accommodated in conveyance carriage 30 can be managed based on the identification information. As a result, it is possible to improve the manageability of conveyance carriage 30 and the component devices. In addition, setup operation by operator H is assisted by device management system 20 managing the component devices and the like. As a result, it is possible to improve the work efficiency of the setup using conveyance carriage 30.

### 8. Modifications of Embodiments

### 8-1. Regarding Position Detection Section 32

In the embodiment, the signal transmitted from beacon device 51 is received to detect current position Pc of conveyance carriage 30. On the other hand, position detection section 32 may detect current position Pc by receiving, for example, radio waves or infrared signals used for the mutual communication. Specifically, a wireless signal used for the mutual communication between conveyance carriage 30 and management server 40 can be applied.

Position detection section 32 may detect current position Pc without using an external signal. For example, position detection section 32 may acquire image data by capturing of a camera device that uses at least a part of movement range Rm as a visual field for camera, and may determine current position Pc of conveyance carriage 30 by image processing the image data. In addition, position detection section 32 may receive a signal periodically transmitted from conveyance carriage 30 and determine current position Pc of conveyance carriage 30.

### 8-2. Regarding Device Management System 20

In the embodiment, device management system 20 is configured to recognize current position Pc of conveyance carriage 30 based on the detection result by position detection section 32, and to recognize feeder 122 accommodated in the conveyance carriage 30 based on the identification information by information acquisition section 33. Device management system 20 is configured to perform processing according to the search request from operator H using such a function.

On the other hand, device management system 20 may use current position Pc of conveyance carriage 30 or the like for various management. Specifically, device management system 20 can be used to prevent conveyance carriage 30 and the component devices from being lost, or to prevent erroneous setup and being stored different from the plan, by recognizing current position Pc or the like of conveyance carriage 30. As a result, the manageability of the component devices can be further improved.

In addition, in the embodiment, device management system 20 searches feeder 122 which is a component device in accordance with the search request from operator H. On the other hand, device management system 20 may present the position of the component device to operator H together with, for example, a setup list generated in accordance with the production schedule of the substrate product, in place of or in addition to the search request. At this time, when the component devices are accommodated in conveyance carriage 30, device management system 20 may also present current position Pc of conveyance carriage 30 to operator H. As a result, it is possible to improve the work efficiency of the setup.

In the embodiment, device management system 20 is configured to include management server 40 that stores device information M1 related to the component devices. On the other hand, when it is not necessary to present device information M1 together when presenting the search result, management server 40 may be omitted. At this time, for example, a host computer or the like that manages production line Lp may function as management control section 42. In addition, device management system 20 may be configured in cooperation with production line Lp and storage 71 by allowing conveyance carriage 30 and terminal device 60 to communicate directly with each other.

In the embodiment, conveyance carriage 30 is configured to travel by an operation force from the outside without a driving section or the like. On the other hand, conveyance carriage 30 may have a driving section such as an automated guided vehicle, and may travel in a movement range based on, for example, a control instruction input from the outside. At this time, position detection section 32 may have a function mounted on the driving section, or may be configured to detect current position Pc separately from the driving section. When position detection section 32 is configured separately from the driving section, conveyance carriage 30 can determine current position Pc by position detection section 32 regardless of the operating state of the driving section. In such a configuration, the same effect as in the embodiment can be obtained.

In addition, conveyance carriage 30 may be configured to be a part of a substrate-working machine. For example, conveyance carriage 30 is moved in a state in which multiple feeders 122 are accommodated in a multiple accommodation section 31, and is mounted as component supply device 12 in component mounter 3. At this time, conveyance carriage 30 is supplied with electric power by being mounted on component mounter 3 such that conveyance carriage 30 is in a state to communicate with outside and each of multiple accommodation sections 31 functions as multiple slots 121. With such a configuration, it is possible to setup multiple component devices in advance in accordance with a production schedule of a substrate product, and to collectively unload multiple component devices from substrate-working machine for which a predetermined production has been completed. In such a configuration, the same effect as in the embodiment can be obtained.

### 8-3. Regarding Substrate-Working machine and Component Device

In the embodiment, the component device to be managed by device management system 20 is described as feeder 122. On the other hand, device management system 20 may manage various component devices that configure component mounter 3. Specifically, device management system 20 may manage mounting head 133 of component transfer device 13. In addition, device management system 20 may manage nozzle station 16 that holds multiple suction nozzles 134.

In the embodiment, substrate-working machine including the component devices is described as component mounter 3. On the other hand, device management system 20 may manage various component devices of substrate-working machines that configure production line Lp as long as the component devices are conveyed using conveyance carriage 30. Specifically, device management system 20 may manage a mask used for printing by printer 2, which is one of the substrate-working machines, as a component device.

However, in component mounter 3, the functions required for a mounting process are diverse corresponding to the types of the substrate product to be produced, therefore, the numbers and the types of the component devices are relatively large. In addition, for example, the width of feeder 122 is decreased due to a demand for downsizing, therefore, it is difficult to accurately grasp a specific position. From the above viewpoint, as exemplified in the embodiment, the mode in which feeder 122 is to be managed is particularly useful.

### Reference Signs List

1: Production system, 2: Printer, 3: component mounter, 12: Component supply device, 122: Feeder (component device), 13: Component transfer device, 133: Mounting head, 134: Suction nozzle, 16: Nozzle station, 20: Device management system, 30: Conveyance carriage, 31: accommodation section, 32: position detection section, 33: information acquisition section, 34: Reader device, 35: Notification section, 40: Management server, 41: Storage section, 42: Management control section, 51: Beacon device (transmitter), 60: Terminal device, 71: Storage, 90: Substrate, Rm: Movement range, Pc: Current position, Ps: Self-position, Af: Map, M1: Device information, H: Operator.

## Claims

1. A device management system (20) for substrate-working machines (3) comprising:
a conveyance carriage (30) configured to accommodate a component device (122) exchangeably mounted on a substrate-working machine (3) and used for a predetermined work on a substrate (90), and to be movable within a movement range (Rm) including a storage (71) that stores the component device (122) and including the substrate-working machine (3);
a position detection section (32) configured to detect a current position (Pc) of the conveyance carriage (30) in the movement range (Rm);
an information acquisition section (33) configured to be provided on the conveyance carriage (30) and acquiring identification information (ID) of the component device (122) accommodated in the conveyance carriage (30);
**characterized by**
a management control section (42) configured to manage the conveyance carriage (30) and a location of the component device (122) accommodated in the conveyance carriage (30) based on a detection result by the position detection section (33) and the identification information (ID) acquired by the information acquisition section (33).

2. The device management system (20) for substrate-working machines (3) according to claim 1,
wherein multiple transmitters (51) that are configured to transmit each of predetermined signals are installed in the movement range (Rm), and
the position detection section (32) is provided on the conveyance carriage (30), and is configured to receive signals from the multiple transmitters (51) to detect the current position (Pc) of the conveyance carriage (30).

3. The device management system (20) for substrate-working machines (3) according to claim 2,
wherein each of the multiple transmitters (51) is a beacon device that are configured to transmit a signal corresponding to an installation position, and
the device management system (20) includes multiple conveyance carriages (30) provided with the position detection sections (32) sharing multiple beacon devices (51) in the movement range (Rm).

4. The device management system (20) for substrate-working machines (3) according to any one of claims 1 to 3,
wherein the information acquisition section (33) is configured to acquire the identification information (ID) by communicating with the component device (122) communicatively connected to the conveyance carriage (30).

5. The device management system (20) for substrate-working machines (3) according to any one of claims 1 to 4,
wherein the information acquisition section (33) is configured to acquire the identification information (ID) by reading an identification code attached to the component device (122) accommodated in the conveyance carriage (30).

6. The device management system (20) for substrate-working machines according to any one of claims 1 to 5,
wherein the management control section (42) is configured to receive a search request for a specific component device (122) from an operator (H), searches for the component device (122), and presents the current position (Pc) of the conveyance carriage (30) to the operator (H) as a search result.

7. The device management system (20) for substrate-working machines according to claim 6, further comprising:
a terminal device (60) configured to receive the search request from the operator (H), to being able to acquire a self-position (Ps) in the movement range (Rm),
wherein the management control section (42) is configured to display the current position (Pc) of the conveyance carriage (30) and the self-position (Ps) of the terminal device (60) in an overlapping manner on a map (Af) which indicates the movement range (Rm).

8. The device management system (20) for substrate-working machines (3) according to claim 6 or 7,
wherein the position detection section (32) is configured to periodically acquire the current position (Pc) of the conveyance carriage (30), and
the management control section (42) is configured to present to the operator (H) that the conveyance carriage (30) is outside the movement range (Rm) and a final position detected last by the position detection section (32) as a search result, in a case where it is not possible to acquire the current position (Pc) of the conveyance carriage (30) that accommodates the component device (122) in the search for the component device (122) corresponding to the search request.

9. The device management system (20) for substrate-working machines (3) according to any one of claims 6 to 8,
wherein the conveyance carriage (30) includes
multiple accommodation sections (31) each capable of accommodating of the component device (122), and
multiple notification sections (35) provided corresponding to the multiple accommodation sections (31) and notifying the operator (H) of a position of the component device (122) in the conveyance carriage (30), and
the management control section (42) is configured to present the search result to the operator (H) and to cause the notification section (35) corresponding to the accommodation section (35) accommodating the specific component device (122) to perform the notification.

10. The device management system (20) for substrate-working machines (3) according to any one of claims 6 to 9, further comprising:
a management server (40) configured to store device information related to multiple component devices (122) in association with the identification information (ID),
wherein the management control section (42) is configured to present the device information acquired from the management server (40) to the operator (H) in addition to the search result.

11. The device management system (20) for substrate-working machines (3) according to claim 10,
wherein the device information includes necessity of maintenance of the corresponding component device (122).

12. The device management system (20) for substrate-working machines (3) according to any one of claims 1 to 11,
wherein the conveyance carriage (30) travels by an operation force from the outside, and is used for a predetermined work on the storage (71) or the substrate-working machine (3) in a state of being stopped at a random position in the movement range (Rm).

13. The device management system (20) for substrate-working machines (3) according to any one of claims 1 to 12,
wherein the substrate-working machine (3) is a component mounter mounting a component on the substrate (90), and
the component device (122) is a feeder supplying the component in a mounting process of the component by the component mounter.

## Patentansprüche

1. System (20) für Verwaltung von Vorrichtungen für Substrat-Bearbeitungsmaschinen (3), das umfasst:
einen Transportwagen (30), der so ausgeführt ist, dass er eine Bauteil-Vorrichtung (122) aufnimmt, die austauschbar an einer Substrat-Bearbeitungsmaschine (3) montiert wird und für einen vorgegebenen Arbeitsvorgang an einem Substrat (90) eingesetzt wird, und er innerhalb eines Bewegungsbereiches (Rm) bewegt werden kann, der ein Lager (71) einschließt, das die Bauteil-Vorrichtung (122) lagert und die Substrat-Bearbeitungsmaschine (3) enthält;
einen Teilabschnitt (32) für Positionsermittlung, der so ausgeführt ist, dass er eine aktuelle Position (Pc) des Transportwagens (30) in dem Bewegungsbereich (Rm) ermittelt;
einen Teilabschnitt (33) für Informationserfassung, der so ausgeführt ist, dass er an dem Transportwagen (30) vorhanden ist und Identifikations-Informationen (ID) der in dem Transportwagen (30) aufgenommenen Bauteil-Vorrichtung (122) erfasst;
**gekennzeichnet durch**
einen Teilabschnitt (42) für Verwaltungssteuerung, der so ausgeführt ist, dass er den Transportwagen (30) und einen Ort der in dem Transportwagen (30) aufgenommenen Bauteil-Vorrichtung (122) auf Basis eines Ermittlungsergebnisses des Teilabschnitts (33) für Positionsermittlung sowie der durch den Teilabschnitt (33) für Informationserfassung erfassten Identifikations-Informationen (ID) verwaltet.

2. System (20) für Verwaltung von Vorrichtungen für Substrat-Bearbeitungsmaschinen (3) nach Anspruch 1,
wobei mehrere Sender (51), die so ausgeführt sind, dass sie jedes von vorgegebenen Signalen senden, in dem Bewegungsbereich (Rm) installiert sind, und
der Teilabschnitt (32) für Positionsermittlung an dem Transportwagen (30) vorhanden und so ausgeführt ist, dass er Signale von den mehreren Sendern (51) empfängt, um die aktuelle Position (Pc) des Transportwagens (30) zu ermitteln.

3. System (20) für Verwaltung von Vorrichtungen für Substrat-Bearbeitungsmaschinen (3) nach Anspruch 2,
wobei jeder der mehreren Sender (51) eine Baken-Vorrichtung ist, die so ausgeführt ist, dass sie ein einer Installationsposition entsprechendes Signal sendet, und
das System (20) für Verwaltung von Vorrichtungen mehrere Transportwagen (30) einschließt, die mit den Teilabschnitten (32) für Positionsermittlung versehen sind, die sich mehrere Baken-Vorrichtungen (51) in dem Bewegungsbereich (Rm) teilen.

4. System (20) für Verwaltung von Vorrichtungen für Substrat-Bearbeitungsmaschinen (3) nach einem der Ansprüche 1 bis 3,
wobei der Teilabschnitt (33) für Informationserfassung so ausgeführt ist, dass er die Identifikations-Informationen (ID) erfasst, indem er mit der Bauteil-Vorrichtung (122) kommuniziert, die in Kommunikationsverbindung mit dem Transportwagen (30) steht.

5. System (20) für Verwaltung von Vorrichtungen für Substrat-Bearbeitungsmaschinen (3) nach einem der Ansprüche 1 bis 4,
wobei der Teilabschnitt (33) für Informationserfassung so ausgeführt ist, dass er die Identifikations-Informationen (ID) erfasst, indem er einen Identifikations-Code liest, der an der in dem Transportwagen (30) aufgenommenen Bauteil-Vorrichtung (122) angebracht ist.

6. System (20) für Verwaltung von Vorrichtungen für Substrat-Bearbeitungsmaschinen nach einem der Ansprüche 1 bis 5,
wobei der Teilabschnitt (42) für Verwaltungssteuerung so ausgeführt ist, dass er eine Suchanfrage für eine bestimmte Bauteil-Vorrichtung (122) von einer Bedienungsperson (H) empfängt, nach der Bauteil-Vorrichtung (122) sucht und der Bedienungsperson (H) die aktuelle Position (Pc) des Transportwagens (30) als ein Suchergebnis anzeigt.

7. System (20) für Verwaltung von Vorrichtungen für Substrat-Bearbeitungsmaschinen nach Anspruch 6, das des Weiteren umfasst:
eine Endgerät-Vorrichtung (60), die so ausgeführt ist, dass sie die Suchanfrage von der Bedienungsperson (H) empfängt, um eine Eigenposition (Ps) in dem Bewegungsbereich (Rm) erfassen zu können,
wobei der Teilabschnitt (42) für Verwaltungssteuerung so ausgeführt ist, dass er die aktuelle Position (Pc) des Transportwagens (30) und die Eigenposition (Ps) der Endgerät-Vorrichtung (60) überlappend auf einer Karte (Af) anzeigt, die den Bewegungsbereich (Rm) angibt.

8. System (20) für Verwaltung von Vorrichtungen für Substrat-Bearbeitungsmaschinen (3) nach Anspruch 6 oder 7,
wobei der Teilabschnitt (32) für Positionsermittlung so ausgeführt ist, dass er periodisch die aktuelle Position (Pc) des Transportwagens (30) erfasst, und
der Teilabschnitt (42) für Verwaltungssteuerung so ausgeführt ist, dass er der Bedienungsperson (H) die Tatsache, dass sich der Transportwagen (30) außerhalb des Bewegungsbereiches (Rm) befindet, und eine zuletzt durch den Teilabschnitt (32) für Positionsermittlung erfasste Endposition als ein Suchergebnis dann anzeigt, wenn es bei der Suche nach der Bauteil-Vorrichtung (122) entsprechend der Suchanfrage nicht möglich ist, die aktuelle Position (Pc) des Transportwagens (30) zu erfassen, der die Bauteil-Vorrichtung (122) aufnimmt.

9. System (20) für Verwaltung von Vorrichtungen für Substrat-Bearbeitungsmaschinen (3) nach einem der Ansprüche 6 bis 8,
wobei der Transportwagen (30) einschließt:
mehrere Aufnahme-Teilabschnitte (31), die jeweils in der Lage sind, die Bauteil-Vorrichtung (122) aufzunehmen, und
mehrere Mitteilungs-Teilabschnitte (35), die korrespondierend zu den mehreren Aufnahme-Teilabschnitten (31) vorhanden sind und der Bedienungsperson (H) eine Position der Bauteil-Vorrichtung (122) in dem Transportwagen (30) mitteilen, und
wobei der Teilabschnitt (42) für Verwaltungssteuerung so ausgeführt ist, dass er der Bedienungsperson (H) das Suchergebnis anzeigt und den Mitteilungs-Teilabschnitt (35), der dem Aufnahme-Teilabschnitt (35) entspricht, der die spezifische Bauteil-Vorrichtung (122) aufnimmt, veranlasst, die Mitteilung durchzuführen.

10. System (20) für Verwaltung von Vorrichtungen für Substrat-Bearbeitungsmaschinen (3) nach einem der Ansprüche 6 bis 9, das des Weiteren umfasst:
einen Verwaltungs-Server (40), der so ausgeführt ist, dass er Vorrichtungs-Informationen, die sich auf mehrere Bauteil-Vorrichtungen (122) beziehen, in Verbindung mit den Identifikations-Informationen (ID) speichert,
wobei der Teilabschnitt (42) für Verwaltungssteuerung so ausgeführt ist, dass er der Bedienungsperson (H) zusätzlich zu dem Suchergebnis die von dem Verwaltungs-Server (40) erfassten Vorrichtungs-Informationen anzeigt.

11. System (20) für Verwaltung von Vorrichtungen für Substrat-Bearbeitungsmaschinen (3) nach Anspruch 10,
wobei die Vorrichtungs-Informationen Notwendigkeit von Wartung der entsprechenden Bauteil-Vorrichtung (122) einschließen.

12. System (20) für Verwaltung von Vorrichtungen für Substrat-Bearbeitungsmaschinen (3) nach einem der Ansprüche 1 bis 11,
wobei sich der Transportwagen (30) durch eine Betätigungskraft von außen bewegt und für einen vorgegebenen Arbeitsvorgang an dem Lager (71) oder der Substrat-Bearbeitungsmaschine (3) in einem Zustand eingesetzt wird, in dem er an einer beliebigen Position in dem Bewegungsbereich (Rm) angehalten wird.

13. System (20) für Verwaltung von Vorrichtungen für Substrat-Bearbeitungsmaschinen (3) nach einem der Ansprüche 1 bis 12,
wobei die Substrat-Bearbeitungsmaschine (3) eine Vorrichtung zum Montieren von Bauteilen ist, die ein Bauteil auf dem Substrat (90) montiert, und
die Bauteil-Vorrichtung (122) eine Transportvorrichtung ist, die das Bauteil bei einem Prozess zum Montieren des Bauteils mittels der Vorrichtung zum Montieren von Bauteilen zuführt.

## Revendications

1. Système de gestion de dispositif (20) pour machines de travail de substrat (3), comprenant :
un chariot de convoyage (30) configuré pour loger un dispositif de composant (122) monté de manière échangeable sur une machine de travail de substrat (3) et utilisé pour un travail prédéterminé sur un substrat (90), et pour être mobile dans une plage de déplacement (Rm) comprenant un stockage (71) qui stocke le dispositif de composant (122) et comprenant la machine de travail de substrat (3) ;
une section de détection de position (32) configurée pour détecter une position actuelle (Pc) du chariot de convoyage (30) dans la plage de déplacement (Rm) ;
une section d'acquisition d'information (33) configurée pour être pourvue sur le chariot de convoyage (30) et acquérant de l'information d'identification (ID) du dispositif de composant (122) logé dans le chariot de convoyage (30) ;
**caractérisé par**
une section de contrôle de gestion (42) configurée pour gérer le chariot de convoyage (30) et un emplacement du dispositif de composant (122) logé dans le chariot de convoyage (30) sur la base d'un résultat de détection par la section de détection de position (33) et de l'information d'identification (ID) acquise par la section d'acquisition d'information (33).

2. Système de gestion de dispositif (20) pour machines de travail de substrat (3) selon la revendication 1,
dans lequel de multiples émetteurs (51) qui sont configurés pour transmettre chacun des signaux prédéterminés sont installés dans la plage de déplacement (Rm), et
la section de détection de position (32) est pourvue sur le chariot de convoyage (30) et est configurée pour recevoir des signaux provenant des multiples émetteurs (51) pour détecter la position actuelle (Pc) du chariot de convoyage (30).

3. Système de gestion de dispositif (20) pour machines de travail de substrat (3) selon la revendication 2,
dans lequel chacun des multiples émetteurs (51) est un dispositif de balise configuré pour transmettre un signal correspondant à une position d'installation, et
le système de gestion de dispositif (20) comprend de multiples chariots de convoyage (30) pourvus des sections de détection de position (32) partageant de multiples dispositifs de balise (51) dans la plage de déplacement (Rm) .

4. Système de gestion de dispositif (20) pour machines de travail de substrat (3) selon l'une quelconque des revendications 1 à 3,
dans lequel la section d'acquisition d'information (33) est configurée pour acquérir l'information d'identification (ID) en communiquant avec le dispositif de composant (122) connecté en communication au chariot de convoyage (30).

5. Système de gestion de dispositif (20) pour machines de travail de substrat (3) selon l'une quelconque des revendications 1 à 4,
dans lequel la section d'acquisition d'information (33) est configurée pour acquérir l'information d'identification (ID) en lisant un code d'identification attaché au dispositif de composant (122) logé dans le chariot de convoyage (30).

6. Système de gestion de dispositif (20) pour machines de travail de substrat selon l'une quelconque des revendications 1 à 5,
dans lequel la section de contrôle de gestion (42) est configurée pour recevoir une requête de recherche par un opérateur (H) pour un dispositif de composant spécifique (122), recherche le dispositif de composant (122), et présente la position actuelle (Pc) du chariot de convoyage (30) à l'opérateur (H) comme résultat de recherche.

7. Système de gestion de dispositif (20) pour machines de travail de substrat selon la revendication 6, comprenant en outre :
un dispositif terminal (60) configuré pour recevoir la requête de recherche de l'opérateur (H) afin d'acquérir une position propre (Ps) dans la plage de déplacement (Rm) ,
dans lequel la section de contrôle de gestion (42) est configurée pour afficher la position actuelle (Pc) du chariot de convoyage (30) et la position propre (Ps) du dispositif terminal (60) de manière superposée sur une carte (Af) qui indique la plage de déplacement (Rm).

8. Système de gestion de dispositif (20) pour machines de travail de substrat (3) selon la revendication 6 ou 7,
dans lequel la section de détection de position (32) est configurée pour acquérir périodiquement la position actuelle (Pc) du chariot de convoyage (30), et
la section de contrôle de gestion (42) est configurée pour présenter à l'opérateur (H) que le chariot de convoyage (30) se trouve en dehors de la plage de déplacement (Rm) et une position finale détectée en dernier par la section de détection de position (32) comme résultat de recherche, dans le cas où il n'est pas possible d'acquérir la position actuelle (Pc) du chariot de convoyage (30) qui loge le dispositif de composant (122) lors de la recherche du dispositif de composant (122) correspondant à la requête de recherche.

9. Système de gestion de dispositif (20) pour machines de travail de substrat (3) selon l'une quelconque des revendications 6 à 8, dans lequel le chariot de convoyage (30) comprend
de multiples sections de logement (31), capable chacune de loger le dispositif de composant (122), et
de multiples sections de notification (35) pourvues, correspondant aux multiples sections de logement (31) et notifiant à l'opérateur (H) une position du dispositif de composant (122) dans le chariot de convoyage (30), et
la section de contrôle de gestion (42) est configurée pour présenter le résultat de recherche à l'opérateur (H) et pour amener la section de notification (35) correspondant à la section de logement (35) logeant le dispositif de composant spécifique (122) à mettre en œuvre la notification.

10. Système de gestion de dispositif (20) pour machines de travail de substrat (3) selon l'une quelconque des revendications 6 à 9, comprenant en outre :
un serveur de gestion (40) configuré pour stocker de l'information de dispositif relative à de multiples dispositifs de composant (122) en association avec l'information d'identification (ID),
dans lequel la section de contrôle de gestion (42) est configurée pour présenter l'information de dispositif acquise auprès du serveur de gestion (40) à l'opérateur (H) en plus du résultat de recherche.

11. Système de gestion de dispositif (20) pour machines de travail de substrat (3) selon la revendication 10,
dans lequel l'information de dispositif comprend la nécessité de maintenance du dispositif de composant correspondant (122).

12. Système de gestion de dispositif (20) pour machines de travail de substrat (3) selon l'une quelconque des revendications 1 à 11,
dans lequel le chariot de convoyage (30) se déplace grâce à une force d'actionnement exercée depuis l'extérieur et est utilisé pour un travail prédéterminé sur le stockage (71) ou sur la machine de travail du substrat (3) dans un état d'arrêt à une position aléatoire dans la plage de déplacement (Rm).

13. Système de gestion de dispositif (20) pour machines de travail de substrat (3) selon l'une quelconque des revendications 1 à 12, dans lequel
la machine de travail du substrat (3) est un dispositif de montage de composants qui monte un composant sur le substrat (90), et
le dispositif de composant (122) est un dispositif d'alimentation qui alimente le composant lors d'un processus de montage du composant par le dispositif de montage de composants.
